# EUROPEAN PATENT SPECIFICATION

(11) **EP 0 632 143 B1**
(45) Date of publication and mention of the grant of the patent: **08.10.1997**
(21) Application number: 94830330.0
(22) Date of filing: 01.07.1994
(51) Int. Cl.: C23C 14/28, C23C 14/32, C23C 14/12

(54) **Method for the deposition of large molecules without loss of their properties**
Verfahren zur Abscheidung von grossen Molekülen ohne Verlust von deren Eigenschaften
Procédé pour le dépôt de grandes molécules sans perte de leurs propriétées

(30) Priority: 02.07.1993 IT RM930432
(43) Date of publication of application: 04.01.1995
(73) Proprietor: ENEA ENTE PER LE NUOVE TECNOLOGIE, L'ENERGIA E L'AMBIENTE, I-00198 Roma (IT)
(72) Inventor: Morales, Pietro, I-00162 Roma (IT); Sperandei, Maria, I-01100 Viterbo (IT)
(74) Representative: Di Cerbo, Mario

(56) References cited:
- US-A- 5 094 880
- US-H- H 872
- US-H- H 872
- JOURNAL OF APPLIED PHYSICS, 1 AUG. 1989, USA, VOL. 66, NR. 3, PAGE(S) 1411 - 1422, ISSN 0021-8979 Hansen S G 'Study of ultraviolet-laser ablation products of several polymers using time-of-flight spectroscopy'
- PATENT ABSTRACTS OF JAPAN vol. 17, no. 247 (C-1059) 18 May 1993 & JP-A-04 371 572 (RES DEV CORP OF JAPAN) 24 December 1992

## Description

The present invention refers to a method for the deposition of supramolecular systems, biomolecular systems and, in general, molecules of'large size and/or complexity and/or lability without fragmentation and/or loss of their structural and functional properties.

As it is known, the potential use of certain organic polymers and certain biological molecules to form low dissipation and low noise electronic devices has been recognized for some years now. Organic and biological conductors, proteins acting as biological semiconductors and even polymers with LED (Light Emitting Diode) properties are known. Furthermore, "biomimetic" supramolecular systems with semiconductor properties have been created, by covalent bonding of molecules that are widely used in nature. However, in practical production of electronic devices, however elementary, one encounters the difficulty of depositing the various single component molecules, in their due locations, on an adequate support with nanometric or subnanometric resolution.

All the deposition methods that can be used for this type of molecule produce deposits of macroscopic dimensions, although extremely thin (molecular monolayer). Recent use of scanning probe microscopes (Scanning Probe Microscope, Atomic Force Microscope) now makes it possible to cut a molecular monolayer and remove, with nanometric resolution, the deposited material from the whole of the support with the exception of the required sites; alternatively it is possible to create masks to carry out deposition.

However, these "nanolithographic" methods are not considered practicable, except in the case of scientific demonstrations. (They have been efficiently compared with the construction of a suspension bridge by carving it out of a single block of metal, rather than by assembling the various components as required).

The method according to the present invention, on the contrary, can be used to create a molecular assembly on a support according to patterns of whatever complexity. It is, in fact, based on a non-destructive ionization of the molecules to be deposited and on electric field assisted deposition, said field being easy to localize and move with atomic resolution.

More specifically, the subject of the present invention is a method for the deposition of supramolecular systems, biomolecules and, in general, molecules of large size and/or complexity and/or lability, comprising a combination of the following operations:
- non-destructive vaporization and ionization, induced by the absorption of short pulses of electromagnetic radiation, of said molecules, the vaporization and ionization steps being induced by one and the same or by several, different laser radiation pulses;
- driving the ionized molecules in an electric field, optionally with the insertion of masks; and
- deposition of the ionized molecules on the desired support.

Vaporization can take place under vacuum, in air or under controlled atmospheres.

Vaporization and ionization can take place in the plasma generated by laser radiation focussed on the surface of the material to be vaporized.

The molecules to be vaporized can be embedded in a matrix that effectively absorbs the radiation at the wavelength of the laser used. The matrix can be chosen, for example, from the group comprising cyanohydroxycynamic acid, sinapinic acid, caffeic acid, aminobenzoic acid, 2-5-dihydroxybenzoic acid, vanillic acid, nicotinic acid, pyrazin-carboxylic acid, nitrobenzylic alcohol or the matrix may be the solvent in which the molecule is solubilized, frozen - alone or together with other molecules that increase the laser radiation absorption - into a suitable form, f.i. the form of a thin film.

In certain specific embodiments of the invention, the vaporized molecules can be incorporated into a supersonic molecular beam of a transport gas, for example an inert gas, like nitrogen, to cool them, and can then be ionized by means of a second laser pulse.

In other embodiments of the method according to the present invention, along the path followed by the ions from the volume in which they are produced by the laser beam to the deposition support, an electric field can be applied perpendicular to the ions' path in order to capture the faster, and therefore smaller ions. This field is then sharply switched off just before the arrival of the parent ions, allowing the latter only to reach the deposition surface, which then results uncontaminated by fragmentation products.

The method according to the present invention can be applied with advantage to supramolecular systems and biomolecules, such as amino acids, peptides, proteins, DNA or RNA sequences, antibodies, cells and or subcell components.

In specific embodiments of the present invention vaporization and ionization can be obtained using laser radiation pulses having the following characteristics:
- wavelength from to 15,000 nm
- pulse duration from 1 ps to 100 ns
- power density from 0.05 MW/cm² to 100 MW/cm²

The method according to the present invention can be of great significance in applications of a bioelectronic nature, and in particular in microbioeletronics and in the so-called "nanotechnologies" connected therewith.

The manufacture of an integrated polyfunctional biosensor even of microscopic size can easily be envisaged. As the biomolecule is ionized, it can be driven in an electric field to specific locations. In this way, a biosensor can be constructed (take, for example, an optical type biosensor) in which micrometric size strips of various biological materials are deposited on the surface of the optical fiber. It is also possible to envisage a polyfunctional biosensor in which the various biological components are not spatially separated, but are deposited simultaneously on the same area. A further possibility, to be evaluated in each case, is that of producing deposits of oriented biomolecules by use of the electric field applied and the dipole moment of the molecule.

It is also possible to envisage important applications of the present method for the construction of actual integrated electronic or bioelectronic microcircuits. Recently, a number of proposals have been made for the use of biomolecules as conductors, electronic switches, charge separators, memories. Conventional technologies available for manufacturing purposes, basically speaking nanolithography, are on the other hand considered unsatisfactory. However, it is possible to envisage the use of a tunnelling microscope or the like to create an electric field with extremely high spatial resolution, that can be moved as required to follow patterns of whatever complexity defined by a computer. Using this field, the laser vaporized and ionized biomolecules can be deposited on the support according to patterns with nanometric or subnanometric dimensions, maintaining, as will be seen, their functional characteristics. It is also possible to form deposits of metal conductors or other solid state electronic components, to provide for "extraction" of the signal towards macroscopically accessible areas or to form hybrid silicon-bioelectronic systems.

Supramolecular systems can be obtained by means of deposit of various molecules carried out using the above mentioned method. The deposits of these supramolecular systems can be performed in predetermined sites, in such a way as to form complex systems with predetermined functions.

Up to this point a general description has been given of the method according to the present invention. With the aid of examples, a detailed description of specific embodiments of the invention will now be given, with the aim of giving a better understanding of the objects, characteristics, advantages and forms of application thereof.

Figure 1 shows the mass spectrum of the dipeptide tryptophyl-leucine obtained before (A) and after (B) deposition according to the invention. These mass spectra have been recorded using a linear time of flight mass spectrometer having a flight path of 85 cm, using an extraction potential of 300 V, an acceleration potential of 2000 V and laser vaporization and ionization pulses of 8 ns. The result shows that no fragmentation occurs on impact on the deposition surface.

Figure 2 shows kinetics of catalyzed oxidation of the enzyme peroxidase deposited on mica after having been vaporized and ionized from a matrix of nicotinic acid.

Figure 3 shows a similar kinetics for peroxidase, in this case vaporized and ionized in laser-induced plasma. The results show how the deposited molecules maintain their integrity, not only in terms of mass but also in terms of biological structure and function.

Figure 4 shows the fluorescence from chromophore tagged protein molecules (Bovine Serum Albumine, BSA) that have been recognized and bound by selective anti-BSA antibody molecules: the latter were previously deposited on glass by our method in the microscopic pattern that is clearly visible. The dimension of the fluorescent areas is 65 µm.

Figure 5 shows the fluorescence from fluorescein isothiocyanate molecules deposited on glass thourgh a mask on which the word that is readable was laser drilled. Dimension of each spot 10-15 µm, length of the whole word 400 µm.

### EXAMPLE 1

### Application of the method according to the invention to the deposition of tryptophan (Trp)

A solution of Trp 2.10 ⁻³ M in methanol is prepared, of which 2 µl are allowed to dry on a stainless steel surface adjacent to the nozzle of a supersonic molecular beam of nitrogen. The sample prepared in this way is irradiated with a laser radiation pulse at 266 nm for the duration of 8 ns. With a suitable delay, connected with the time required for the Trp molecules to transit from the steel surface to the region where deposition occurs and where an electric field of 300 V/cm has been applied, the gas produced in this way is irradiated with a second laser radiation pulse at 286 nm, which causes ionization of tryptophan. These ionized molecoles are steered by the electric field onto the deposition support, in which a small hole is made that gives access to a time of flight mass spectrometer to check the integrity of the molecules. Mass spectrum analysis showed negligible fragmentation; analysis by scanning electron microscopy showed a very homogeneous deposit. Adhesion of the deposit to the support was evaluated by sticking a piece of sticky-tape firmly onto the deposit, and then tearing it off quickly. The deposit suffered no damage following removal of the tape.

### EXAMPLE 2

### Application of the method according to the invention to the deposition of tryptophyl-leucine (Trp-Leu)

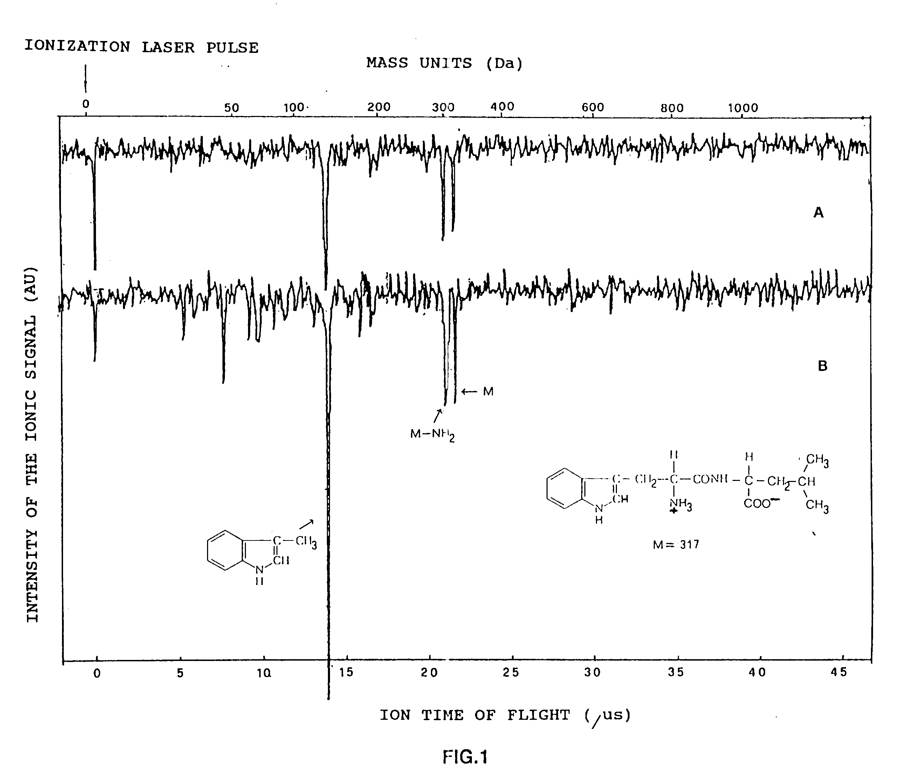

The test methods were similar to those used in Example 1. In the experiment to which figure 1 refers, the supersonic jet cooling is missing. The mass spectrum of the vaporized and ionized material (see figure 1A) shows, as well as the ion of the molecule in question, a first fragment without the amino-terminal segment and a second fragment consisting of methylindole. By subjecting the sample thus deposited to the same irradiation process indicated above, a second deposit is obtained, mass analysis of which shows a negligible amount of fragmentation with respect to the first deposit (see figure 1B).

### EXAMPLE 3

### Application of the method according to the invention to the deposition of the enzyme peroxidase (from horseradish)

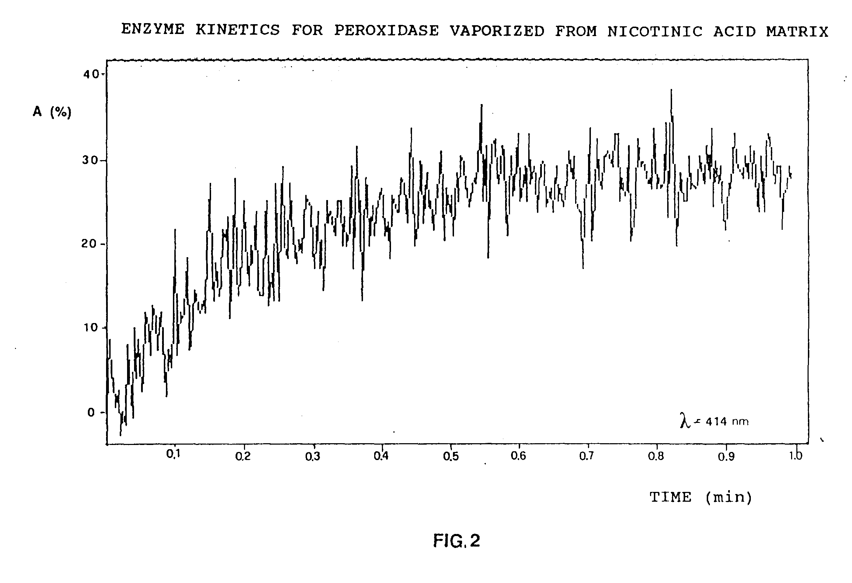

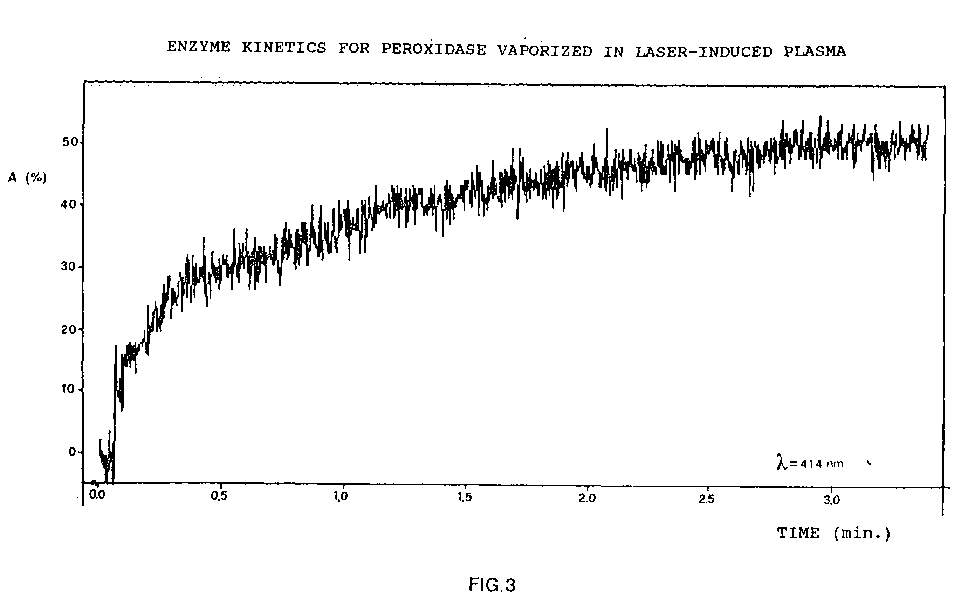

A) Vaporization and ionization using laser radiation pulses
   An aqueous solution of horseradish peroxidase and nicotinic acid with a molar ratio 10⁻² is prepared, and allowed to evaporate on a stainless steel support. After placing it in a vacuum at pressures lower than 10⁻⁶ Torr 1.3.10⁻⁴ Pa, a field of 400 V/cm is applied to this sample, to drive ions towards the mica deposition support. The sample is vaporized and ionized with laser pulses at 266 nm of the duration of 8 ns and with a power density of approximately 30 MW/cm². (Widely varying conditions can be employed according to the morphology of the initial sample). The sample deposited as above was subjected to an enzyme activity test. It was reacted wit ABTS (2,2'-azino-di-3-ethyl-benzothiazoline-6-sulphonic acid) and hydrogen peroxide (H₂O₂) with the aim of observing under spectrophotometry the evolution of the absorption band for oxidated ABTS, which exhibits a maximum at 417 nm. The test shows a remarkable enzyme induced reaction kinetics. This meas that the enzymatic function is still present in the deposited enzyme (figure 2).
B) Vaporization in laser-induced plasma.
   The sample was prepared by depositing 500 µg of lyophilized horseradish peroxidase on a stainless steel support, very slightly dampened with distilled water to make the protein adhere. This sample was put into a vacuum chamber at pressures of lower thant 10⁻⁶ Torr (1.3.10⁻⁴Pa). A field of 3 kV/cm was applied to this sample under vacuum. The samples was then irradiated with laser pulses of 8 ns, wave length 266 nm, and with a power density equal to 80 MW/cm². The samples prepared as above was finally subjected to the enzyme activity test illustrated above. In this case too enzymatic activity was seen to be maintained (figure 3).
   Both in the case of vaporization with laser pulses, and in the case of vaporization in laser-induced plasma, the deposited enzyme was subjected to stability tests. That is to say, the enzyme activity test was repeated, after days and weeks, on samples stored at room temperature. In both cases, the immobilized enzyme remained active.

### EXAMPLE 4

### Application of the method according to the invention to the deposition of the laccase enzyme from "Pyricularia oryzae"

Depositions of the laccase enzyme from "Pyricularia oryzae" were performed using the same methods used for deposition of peroxidase. Results similar to those seen for the peroxidase enzyme were obtained.

### EXAMPLE 5

### Application of the method of the invention to the deposition of horseradish peroxidase on a surface perpendicular to the surface from which vaporization occurs

This application shows that the depositions of the inventions are enzymatically active even in the absence of neutral sputtered molecules, and that active enzyme molecules can be ionized and steered in an electric field. The neutral sputtered molecules and the ionized ones are separated by applying the field perpendicularly to the propagation direction of the vapour plume, which is normal to the vaporization surface; ions only are thus deflected and collected on a small electrode (2 mm) which is then tested for enzymatic activity. In our tests the electrode turned out to be enzimatically very strongly active.

### EXAMPLE 6

### Application of the method of the invention to the deposition of an anti-BSR antibody from mouse

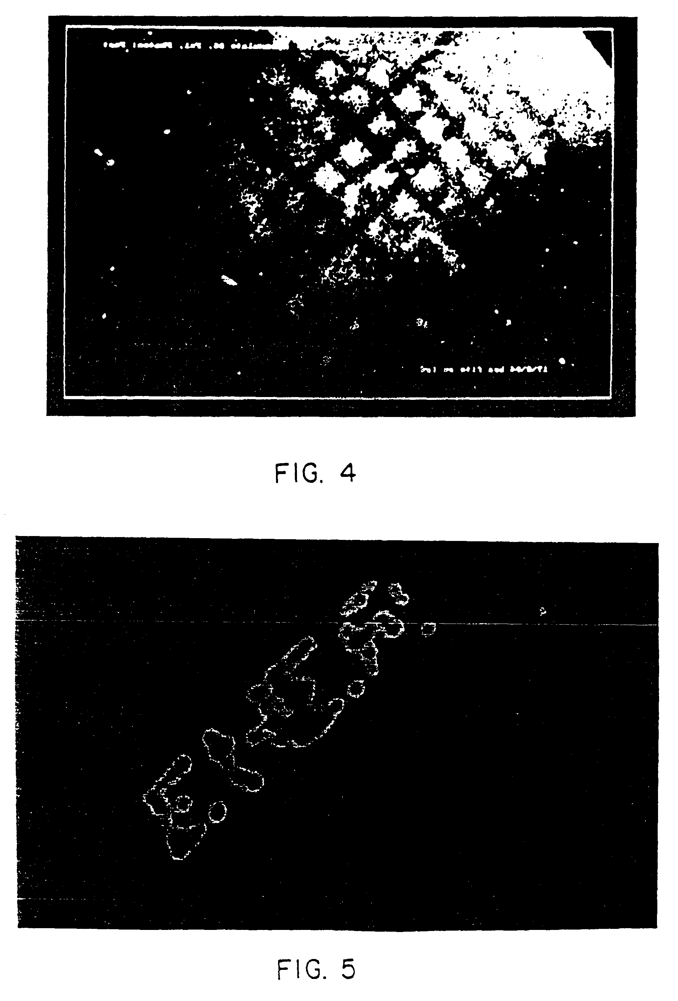

A solution of antibody (0.2 mg/ml) and ferulic acid (1 mg/ml) in distilled water was first prepared. 10 µl of such solution were frozen on the tip of a temperature controlled cold finger inserted into the vacuum vessel. A copper mesh (100 µm period) was used as a mask by placing it in close contact with the deposition glass surface so that the deposition reproduces the mesh pattern. The frozen sample was then irradiated by about 2000 laser pulses at 355 nm with a power density of 50-100 MW/cm² while an electric field of 1kV/cm was applied between frozen sample and glass. After irradiation the coated glass was extracted from the vacuum vessel and the mesh was removed; the glass was then dipped for 5 minutes into an aqueous solution of the specific antigen (Bovine Serum Albumine) covalently conjugated to the strongly fluorescent molecule Fluorescein Isothiocyanate (FITC); after accurate rinsing in distilled water, the coated glass was examined with a microscope by laser excitation at 488 nm of FITC. As we can observe from fig. 4 the mesh pattern is clearly observable, showing that the antigen was concentraed only in those areas where the antibody had been immobilized, and thus proving that the antibody is still capable of recognizing and binding the antigen.

### EXAMPLE 7

### Application of the method of the invention to the deposition of fluorescein isothiocyanate (FITC)

A solution of FITC was prepared as follows; 0.3 µl of a stock solution (0.1 mg/µl) of FITC in dimethyl sulfoxide were mixed to 10 µl ethanol and then added to 5 ml of a ferulic acid solution (1.2 mg/ml) in 4:1 water/ethanol. Such solution was then frozen, as in example 6 on the tip of the cold finger in the vacuum vessel. A mask was prepared by laser drilling 10 µm holes into a 12 µm aluminum foil in a pattern that represents a written four letter word 400 µm long (ENEA). In this application the electric field was not applied thus collecting both neutrals and ions on the deposit. The sample was then irradiated by a few thousand 355 nm laser pulses with a power density of 5-10 MW/cm². Once the deposition was effected and the mask removed we observed the fluorescent word with a 488 nm laser illuminated microscope, as shown in fig. 5.

## Claims

1. A method for the deposition of supramolecular systems, biomolecules and, in general, molecules of large size and/or complexity and/or lability, comprising a combination of the following operations:
- non-destructive vaporization and ionization, induced by the absorption of short pulses of electromagnetic radiation, of said molecules, the vaporization and ionization steps being induced by one and the same or by several, different laser radiation pulses;
- driving of the ionized molecule in an electric field, optionally with the insertion of masks; and
- deposition of the ionized molecules on the desired support.

2. The method for the deposition of supramolecular systems, biomolecules and, in general, molecules of large size and/or complexity and/or lability according to claim 1, in which vaporization takes place under vacuum, in air or under controlled atmospheres.

3. The method for the deposition of supramolecular systems, biomolecules and, in general, molecules of large size and/or complexity and/or lability according to claim 1 or 2, in which vaporization and ionization are obtained in the plasma generated by laser radiation focussed on the surface of the material to be vaporized.

4. The method for the deposition of supramolecular systems, biomolecules and, in general, molecules of large size and/or complexity and/or lability according to claim 1, 2 or 3, in which the molecules, before being vaporized and ionized, are embedded in a matrix that effectively absorbs the radiation at the wave length of the laser used.

5. The method for the deposition of supramolecular systems, biomolecules and, in general, molecules of large size and/or complexity and/or lability according to claim 4, in which the matrix can be chosen from the group comprising nicotinic acid, ferulic acid, cyanohydroxycynamic acid, sinapinic acid, caffeic acid, aminobenzoic acid, 2-5-dihydroxybenzoic acid, vanillic acid, nicotinic acid, pyrazin-carboxylic acid, nitrobenzylic alcohol, or the matrix is the solvent in which the molecule is solubilized, frozen - alone or together with other molecules that increase the laser radiation absorption - into a suitable form, for instance of a thin film.

6. The method for the deposition of supramolecular systems, biomolecules and, in general, molecules of large size and/or complexity and/or lability according to any one of the preceding claims, in which the vaporized molecules are incorporated into a supersonic molecular beam of a transport gas and then ionized by means of a second laser pulse.

7. The method for the deposition of supramolecular systems, biomolecules and, in general, molecules of large size and/or complexity and/or lability according to claim 6, in which the supersonic molecular beam is of inert gas, for example nitrogen.

8. The method for the deposition of supramolecular systems, biomolecules and, in general, molecules of large size and/or complexity and/or lability according to any one of the preceding claims, in which, along the path followed by the ions from the volume in which they are produced by the laser beam to the deposition support, an electric field that can be sharply switched off is applied in a different direction from said path, said electric field being capable of capturing the passing ions of a size smaller than that of the molecule to be deposited.

9. The method for the deposition of supramolecular systems, biomolecules and, in general, molecules of large size and/or complexity and/or lability according to any one of the preceding claims, in which the supramolecular systems and the molecules of interest are chosen from the group comprising biomolecules, such as amino acids, peptides, proteins, antibodies, DNA sequences, RNA sequences, cells and/or subcell components.

10. The method for the deposition of supramolecular systems, biomolecules and, in general, molecules of large size and/or complexity and/or lability according to any one of the preceding claims, in which the electric field used for deposition is spatially located in an area of nanometric dimensions by means of an extremely thin probe similar to those used in scanning probe microscopes (Scanning tunnelling microscope, atomic force microscope, scanning probe interoscope) overlooking the surface on which the deposition is to be made.

11. The method for the deposition of supramolecular systems, biomolecules and, in general, molecules of large size and/or complexity and/or lability according to claim 10, in which the probe defining the electric field is moved using sub-micrometric movement systems managed by a computer in order to create deposits according to predetermined models.

12. The method for the deposition of supramolecular systems, biomolecules and, in general, molecules of large size and/or complexity and/or lability according to claim 11, in which different molecules are deposited, using the same apparatus, so as to form complex supramolecular systems.

13. The method for the deposition of supramolecular systems, biomolecules and, in general, molecules of large size and/or -complexity and/or lability according to any one of the preceding claims, in which vaporization and ionization are obtained using laser radiation pulses having the following characteristics:
- wavelength from 150 to 15,000 nm
- pulse duration from 1 ps to 100 ns
- power density from 0.05 MW/cm² to 100 MW/cm².

## Patentansprüche

1. Verfahren zur Abscheidung von supramolekularen Systemen, Biomolekülen und allgemein Molekülen mit großer Größe und/oder Komplexität und/oder Labilität, umfassend eine Kombination der folgenden Schritte:
Zerstörungsfreie Verdampfung und Ionisierung dieser Moleküle, die durch die Absorption von kurzen Pulsen elektromagnetischer Strahlung induziert wird, wobei die Verdampfungs- und Ionisierungsschritte durch ein und denselben oder durch mehrere verschiedene Laserstrahlungspulse induziert werden;
Beschleunigen des ionisierten Moleküls in einem elektrischen Feld, gegebenenfalls unter Einfügung von Masken; und
Abscheiden der ionisierten Moleküle auf dem gewünschten Träger.

2. Verfahren zur Abscheidung von supramolekularen Systemen, Biomolekülen und allgemein Molekülen mit großer Größe und/oder Komplexität und/oder Labilität nach Anspruch 1, in welchem die Verdampfung unter Vakuum, in Luft oder unter kontrollierten Atmosphären stattfindet.

3. Verfahren zur Abscheidung von supramolekularen Systemen, Biomolekülen und allgemein Molekülen mit großer Größe und/oder Komplexität und/oder Labilität nach Anspruch 1 oder 2, in welchem die Verdampfung und Ionisierung in dem Plasma erhalten wird, das durch Laserstrahlung erzeugt wird, die auf die Oberfläche des zu verdampfenden Materials fokussiert ist.

4. Verfahren zur Abscheidung von supramolekularen Systemen, Biomolekülen und allgemein Molekülen mit großer Größe und/oder Komplexität und/oder Labilität nach Anspruch 1, 2 oder 3, in welchem die Moleküle, bevor sie verdampft und ionisiert werden, in eine Matrix eingebettet werden, die die Strahlung bei der Wellenlänge des verwendeten Lasers wirksam absorbiert.

5. Verfahren zur Abscheidung von supramolekularen Systemen, Biomolekülen und allgemein Molekülen mit großer Größe und/oder Komplexität und/oder Labilität nach Anspruch 4, in welchem die Matrix aus der Gruppe umfassend Nikotinsäure, Ferulasäure, -Cyanohydroxyzimtsäure, Sinapinsäure, Kaffeesäure, Aminobenzoesäure, 2,5-Dihydroxybenzoesäure, Vanillinsäure, Nikotinsäure, Pyrazincarbonsäure, Nitrobenzylalkohol ausgewählt werden kann, oder die Matrix das Lösungsmittel ist, in dem das Molekül solubilisiert ist, welches allein oder zusammen mit anderen Molekülen, welche die Absorption der Laserstrahlung erhöhen, in einer geeigneten Form, z.B. als Dünnfilm, gefroren vorliegt.

6. Verfahren zur Abscheidung von supramolekularen Systemen, Biomolekülen und allgemein Molekülen mit großer Größe und/oder Komplexität und/oder Labilität nach einem der vorhergehenden Ansprüche, in welchem die verdampften Moleküle in einen Überschall-Molekularstrahl eines Transport-gases eingebracht und dann mittels eines zweiten Laserpulses ionisiert werden.

7. Verfahren zur Abscheidung von supramolekularen Systemen, Biomolekülen und allgemein Molekülen mit großer Größe und/oder Komplexität und/oder Labilität nach Anspruch 6, in welchem der Überschall-Molekularstrahl aus einem Inertgas, z.B. Stickstoff, gebildet ist.

8. Verfahren zur Abscheidung von supramolekularen Systemen, Biomolekülen und allgemein Molekülen mit großer Größe und/oder Komplexität und/oder Labilität nach einem der vorhergehenden Ansprüche, in welchem entlang des Weges, den die Ionen von dem Volumen, in welchem sie durch den Laserstrahl erzeugt werden, bis zu dem Träger, an dem sie abgeschieden werden, zurücklegen, ein elektrisches Feld, das plötzlich abgeschaltet werden kann, in einer von diesem Weg verschiedenen Richtung angelegt wird, wobei dieses elektrische Feld die durchgehenden Ionen mit einer geringeren Größe als derjenigen des abzuscheidenden Moleküls abfangen kann.

9. Verfahren zur Abscheidung von supramolekularen Systemen, Biomolekülen und allgemein Molekülen mit großer Größe und/oder Komplexität und/oder Labilität nach einem der vorhergehenden Ansprüche, in welchem die supramolekularen Systeme und die in Frage kommenden Moleküle ausgewählt sind aus der Gruppe umfassend Biomoleküle wie Aminosäuren, Peptide, Proteine, Antikörper, DNA-Sequenzen, RNA-Sequenzen, Zellen und/oder subzelluläre Bestandteile.

10. Verfahren zur Abscheidung von supramolekularen Systemen, Biomolekülen und allgemein Molekülen mit großer Größe und/oder Komplexität und/oder Labilität nach einem der vorhergehenden Ansprüche, in welchem das zur Abscheidung verwendete elektrische Feld räumlich in einem Gebiet mit Abmessungen im Nanometer-Bereich angeordnet ist mittels einer extrem dünnen Sonde, die den Sonden ähnelt, die in Rastermikroskopen (Raster-Tunnel-Mikroskop, Raster-Kraft-Mikroskop, Raster-Interoskop) verwendet werden, welche sich über der Oberfläche befindet, auf der die Abscheidung erfolgen soll.

11. Verfahren zur Abscheidung von supramolekularen Systemen, Biomolekülen und allgemein Molekülen mit großer Größe und/oder Komplexität und/oder Labilität nach Anspruch 10, in welchem die Sonde, die das elektrische Feld definiert, unter Verwendung von computergesteuerten submikrometrischen Bewegungssystemen bewegt wird, um Abscheidungen nach vorgegebenen Mustern zu erzeugen.

12. Verfahren zur Abscheidung von supramolekularen Systemen, Biomolekülen und allgemein Molekülen mit großer Größe und/oder Komplexität und/oder Labilität nach Anspruch 11, in welchem verschiedene Moleküle abgeschieden werden, wobei die gleiche Vorrichtung verwendet wird, so daß komplexe supramolekulare Systeme gebildet werden.

13. Verfahren zur Abscheidung von supramolekularen Systemen, Biomolekülen und allgemein Molekülen mit großer Größe und/oder Komplexität und/oder Labilität nach einem der vorhergehenden Ansprüche, in welchem die Verdampfung und Ionisierung unter Verwendung von Laserstrahlungspulsen mit den folgenden Kennzeichen erhalten werden:
| | |
|---|---|
| Wellenlänge | von 150 bis 15 000 nm |
| Pulsdauer | von 1 ps bis 100 ns |
| Leistungsdichte | von 0,05 MW/cm² bis 100 MW/cm² |

## Revendications

1. Procédé pour le dépôt de systèmes supramoléculaires, biomolécules et en général molécules de grande taille et/ou de grande complexité et/ou fragilité, comprenant une combinaison des opérations suivantes :
- vaporisation non destructive et ionisation induite par l'absorption de courtes impulsions de radiation électromagnétique, de ces molécules, les étapes de vaporisation et d'ionisation étant induites par la seule et même ou par plusieurs impulsions de radiation laser différentes ;
- entraînement de la molécule ionisée dans un champ électrique, facultativement avec l'insertion de masques ; et
- dépôt des molécules ionisées sur le support souhaité.

2. Procédé pour le dépôt de systèmes supramoléculaires, biomolécules et en général molécules de grande taille et/ou de grande complexité et/ou fragilité selon la revendication 1, dans lequel la vaporisation s'effectue sous vide, à l'air ou sous atmosphère contrôlée.

3. Procédé pour le dépôt de systèmes supramoléculaires, biomolécules et en général molécules de grande taille et/ou de grande complexité et/ou fragilité selon la revendication 1 ou 2, dans lequel la vaporisation et l'ionisation sont obtenues dans le plasma généré par radiation laser focalisée sur la surface du matériau à vaporiser.

4. Procédé pour le dépôt de systèmes supramoléculaires, biomolécules et en général molécules de grande taille et/ou de grande complexité et/ou fragilité selon la revendication 1, 2 ou 3, dans lequel les molécules, avant d'être vaporisées et ionisées, sont enrobées dans une matrice qui absorbe efficacement le rayonnement de la longueur d'onde du laser utilisé.

5. Procédé pour le dépôt de systèmes supramoléculaires, biomolécules et en général molécules de grande taille et/ou de grande complexité et/ou fragilité selon la revendication 4, dans lequel la matrice peut être choisie dans le groupe comprenant l'acide nicotinique, l'acide férulique et l'acide cyanohydroxycynamique, l'acide sinapinique, l'acide caféique, l'acide aminobenzoïque, l'acide 2-5-dihydroxybenzoïque, l'acide vanillique, l'acide nicotinique, l'acide pyrazin-carboxylique, l'alcool nitrobenzylique ou la matrice est le solvant dans lequel la molécule est solubilisée, congelée - seule ou conjointement avec d'autres molécules qui augmentent l'absorption du rayonnement laser - sous une forme appropriée, par exemple sous la forme d'une pellicule mince.

6. Procédé pour le dépôt de systèmes supramoléculaires, biomolécules et en général molécules de grande taille et/ou de grande complexité et/ou de grande fragilité selon l'une quelconque des revendications précédentes, dans lequel les molécules vaporisées sont incorporées dans un faisceau moléculaire supersonique d'un gaz transporteur et sont ensuite ionisées au moyen d'une seconde impulsion laser.

7. Procédé pour le dépôt de systèmes supramoléculaires, biomolécules et en général molécules de grande taille et/ou de grande complexité et/ou de grande fragilité selon la revendication 6, dans lequel le faisceau moléculaire supersonique est un gaz inerte, par exemple l'azote.

8. Procédé pour le dépôt de systèmes supramoléculaires, biomolécules et en général molécules de grande taille et/ou de grande complexité et/ou de grande fragilité selon l'une quelconque des revendications précédentes, dans lequel on applique le long du trajet suivi par les ions à partir du volume dans lequel ils sont produits par le faisceau laser sur le support de dépôt, un champ électrique pouvant être brusquement coupé, dans une direction différente à ce trajet, le champ électrique étant capable de capturer les ions passant d'une taille inférieure à celle de la molécule à déposer.

9. Procédé pour le dépôt de systèmes supramoléculaires, biomolécules et en général molécules de grande taille et/ou de grande complexité et/ou de grande fragilité selon l'une quelconque des revendications précédentes, dans lequel les systèmes supramoléculaires et les molécules concernés sont choisis dans le groupe comprenant des biomolécules, telles que des acides aminés, peptides, protéines, anticorps, séquences ADN, séquences ARN, cellules et/ou composants sous-cellulaires.

10. Procédé pour le dépôt de systèmes supramoléculaires, biomolécules et en général molécules de grande taille et/ou de grande complexité et/ou de grande fragilité selon l'une quelconque des revendications précédentes, dans lequel le champ électrique utilisé pour le dépôt est situé spatialement dans une zone de dimension nanométrique au moyen d'une sonde extrêmement mince similaire à celle utilisée dans les microscopes à sonde de balayage (microscope tunnel à balayage, microscope à force atomique, interoscope à sonde de balayage) surveillant la surface sur laquelle le dépôt doit être effectué.

11. Procédé pour le dépôt de systèmes supramoléculaires, biomolécules et en général molécules de grande taille et/ou de grande complexité et/ou de grande fragilité selon la revendication 10, dans lequel la sonde définissant le champ électrique est déplacée en utilisant des systèmes à mouvement sous-micrométrique gérés par un ordinateur pour créer des dépôts selon des modèles prédéterminés.

12. Procédé pour le dépôt de systèmes supramoléculaires, biomolécules et en général molécules de grande taille et/ou de grande complexité et/ou de grande fragilité selon la revendication 11, dans lequel différentes molécules sont déposées en utilisant le même appareil de façon à former des systèmes supramoléculaires complexes.

13. Procédé pour le dépôt de systèmes supramoléculaires, biomolécules et en général molécules de grande taille et/ou de grande complexité et/ou de grande fragilité selon l'une quelconque des revendications précédentes, dans lequel la vaporisation et l'ionisation sont obtenues en utilisant des impulsions de radiation laser ayant les caractéristiques suivantes :
- longueur d'onde de 150 à 15 000 nm
- durée d'impulsion de 1 ps à 100 ns
- densité de puissance de 0,05 MW/cm² à 100 MW/cm².
